# EUROPÄISCHE PATENTANMELDUNG

(11) **EP 3 490 353 A1**
(43) Veröffentlichungstag der Anmeldung: **29.05.2019**
(21) Anmeldenummer: 17203775.6
(22) Anmeldetag: 27.11.2017
(51) Int. Cl.: H05K 7/20

(54) **KÜHLSYSTEM MIT PARALLELEN KÜHLKANÄLEN**

(71) Anmelder: Siemens Aktiengesellschaft, 80333 München (DE)
(72) Erfinder: Knauer, Hans, 91359 Leutenbach (DE)

(57) **Zusammenfassung**

Die Erfindung betrifft ein Kühlsystem (1) für einen Stromrichter (2). Zur Verbesserung des Kühlsystems wird vorgeschlagen, das Kühlsystem mit einem ersten Kühlkanal (11) und einem zweiten Kühlkanal (12) auszustatten, Wobei der erste und der zweite Kühlkanal (11,12) zumindest abschnittsweise parallel angeordnet sind, wobei im Bereich der parallelen Anordnung der erste Kühlkanal (11) zur Kühlung von Halbleitern (21) des Stromrichters (2) ausgebildet ist, wobei im Bereich der parallelen Anordnung der zweite Kühlkanal (12) zur Kühlung von Zwischenkreiskondensatoren (22) des Stromrichters (2) ausgebildet ist. Ferner betrifft die Erfindung einen Stromrichter (2) mit einem derartigen Kühlsystem (1).

## Beschreibung

Die Erfindung betrifft ein Kühlsystem für einen Stromrichter. Ferner betrifft die Erfindung ein Stromrichter mit einem derartigen Kühlsystem.

Stromrichter zur Umwandlung von elektrischer Energie erzeugen Verlustleisung, die sich in Verlustwärme zeigen. Diese Wärme muss aus den entsprechenden Bauteilen abgeführt werden, um diese vor Beschädigungen zu schützen. In einem Stromrichter entsteht Verlustleisung im Besonderen im Leistungsteil. Dort werden unterschiedliche elektrische Komponenten eingesetzt, die sich im Betrieb aufgrund elektrischer Verluste erwärmen und gekühlt werden müssen um eine erforderliche Lebensdauer der Komponenten gewährleisten zu können. Dies sind im Wesentlichen die Halbleiter (z.B. IGBT's) und die Zwischenkreiskondensatoren. Da die Lebensdauer von Zwischenkreiskondensatoren sehr stark durch die Umgebungstemperatur beeinflusst wird, sollte diese ca. 70°C nicht übersteigen um Standardkomponenten verwenden zu können. Diese Standardkomponenten sind preisgünstig am Markt verfügbar und wirken sich auf niedrige Herstellkosten des Stromrichters aus.

Aufgrund der geringen zulässigen Umgebungstemperatur für die Zwischenkreiskondensatoren gibt es eine Vorgabe hinsichtlich der Anordnung in einem luftgekühlten Leistungsteil. Dabei werden die Zwischenkreiskondensatoren in einem Luftstrom zur Kühlung entweder vor den Halbleitern oder mittels Luft-Bypass angeordnet. So wird sichergestellt, dass sie mit kühler, d.h. nicht vorerwärmter, Kühlluft versorgt werden.

Der Erfindung liegt die Aufgabe zugrunde ein Kühlsystem für einen Stromrichter zu verbessern.

Diese Aufgabe wird durch ein Kühlsystem für einen Stromrichter mit einem ersten Kühlkanal und einem zweiten Kühlkanal gelöst, wobei der erste und der zweite Kühlkanal zumindest abschnittsweise parallel angeordnet sind, wobei im Bereich der parallelen Anordnung der erste Kühlkanal zur Kühlung von Halbleitern des Stromrichters ausgebildet ist, wobei im Bereich der parallelen Anordnung der zweite Kühlkanal zur Kühlung von Zwischenkreiskondensatoren des Stromrichters ausgebildet ist. Ferner wird die Aufgabe durch einen Stromrichter mit einem derartigen Kühlsystem gelöst.

Vorteilhafte Ausgestaltungen der Erfindung sind in den abhängigen Ansprüchen angegeben.

Der Erfindung liegt die Erkenntnis zugrunde, dass eine gute Versorgung mit hinreichend kühlem Kühlmedium, beispielsweise mit Luft oder Wasser, durch eine parallele Anordnung von zwei Kühlkanälen zur Kühlung von Zwischenkreiskondensatoren und Halbleitern im Gerät erzielt werden kann. Die Halbleiter werden aufgrund der hohen schaltbaren Ströme auch als Leistungshalbleiter bezeichnet. Dazu werden für diese beiden unterschiedlichen Komponenten direkt angeströmte und hermetisch getrennte Kühlkanäle vorgesehen. Durch die beiden Kühlkanale werden sowohl Zwischenkreiskondensatoren als auch die Halbleiter mit einem nicht vorerwärmten Kühlmedium gekühlt. Für die Zwischenkreiskondensatoren hat dies den Vorteil, dass zulässige Maximaltemperaturen zuverlässig eingehalten werden. Gleichzeitig kann die deutlich höhere Verlustleistung der Halbleiter zuverlässig abgeführt werden. Eine gegenseitige Beeinflussung kann dabei auf einfache Weise durch die parallele Anordnung vermieden werden. Neben den thermischen Vorteilen kann mit den beiden Kühlkanälen auch ein relativ einfacher, niederinduktiver Geräteaufbau mit sehr einfachen Stromschienen zur Stromführung für die DC- und AC-Schienen erreicht werden. Aufgrund dieser Anordnung lässt sich das Bauvolumen des Gesamtgerätes sehr kompakt gestalten.

Bei einer vorteilhaften Ausgestaltung der Erfindung sind die Kühlkanale als Luftkanäle ausgebildet. Die Verwendung von Luft hat sich als besonders vorteilhaft erwiesen. Diese kann der Umgebung entnommen werden und mittels der Kühlkanäle den zu kühlenden Komponenten zugeführt werden. Eine Aufteilung der Kühlluft auf zwei parallele Kühlkanäle ist dabei problemlos möglich. Im Gegensatz zur Kühlung mit dem Kühlmedium Wasser kann auf einen Rückkühler, der die Wärme im Wasser an die Umgebung abgibt, verzichtet werden. Damit lässt sich ein besonders einfach aufgebautes und gleichzeitig sehr wirkungsvolles Kühlsystem realisieren.

Bei einer weiteren vorteilhaften Ausgestaltung der Erfindung weist das Kühlsystem genau einen Lüfter auf, der derart angeordnet ist, Kühlluftströme im ersten und im zweiten Kühlkanal zu erzeugen. Die gesamte benötigte Kühlluft für beide Luftkanäle kann bei dieser Ausgestaltung durch nur einen Lüfter an die Zwischenkreiskondensatoren und die Halbleiter herangeführt werden. Der Lüfter erzeugt dabei Kühlluftströme sowohl im ersten wie auch im zweiten Kühlkanal. Dabei wird die benötigte Kühlluft vom Lüfter in die beiden Kühlkanäle geblasen.

Bei einer weiteren vorteilhaften Ausgestaltung der Erfindung weist das Kühlsystem einen Luftverteiler auf, wobei der Luftverteiler derart ausgebildet ist, den Luftstrom zwischen dem ersten Kühlkanal und dem zweiten Kühlkanal im Verhältnis 90:10 aufzuteilen. Da die Zwischenkreiskondensatoren zwar eine möglichst geringe Temperatur des Kühlmediums benötigen aber die Verlustleistung in den Halbleitern deutlich größer ist als in den Zwischenkreiskondensatoren hat es sich als vorteilhaft erwiesen, den Gesamtluftstrom über einen Luftverteiler im Verhältnis von 90:10 (Luftmenge Halbleiter im Verhältnis zu Zwischenkreiskondensator) aufzuteilen. Untersuchungen haben ergeben, dass Aufteilungen im Bereich 80:20 bis 95:5 gute und vor allem gleichmäßige Kühlungsergebnisse mit sich bringen.

Der Luftverteiler kann dabei für die Aufteilung der Luft auf die beiden Kühlkanäle Öffnungen unterschiedlicher Größe aufweisen, so dass sich das entsprechende Aufteilungsverhältnis ergibt. Alternativ oder ergänzend können diese Öffnungen mit beweglichen Klappen ausgestattet sein, mit denen das Verhältnis der Aufteilung anpassbar ist. Der Vorteil der Anpassung liegt daran, dass auf unterschiedliche Verlustleistungsaufteilungen, beispielsweise abhängig vom Betriebspunkt des Stromrichters reagiert werden kann und die Kühlung für beide Komponenten optimal gestaltet werden kann. Die Aufteilung kann beispielsweise auch in Abhängigkeit der Temperatur der Zwischenkreiskondensatoren und/oder der Halbleiter gesteuert oder geregelt werden.

Eine weitere Möglichkeit, die Luftaufteilung auf die zwei Kühlkanäle vorzunehmen ist, ein Mittel zur Reduzierung des Drucks für mindestens einen der Kühlkanäle vorzusehen. Damit lässt sich ebenfalls auf einfache Weise die Aufteilung der Kühlluftmenge auf die beiden Kühlkanäle beeinflussen.

Bei einer weiteren vorteilhaften Ausgestaltung der Erfindung sind der erste und der zweite Kühlkanal im Bereich der parallelen Anordnung räumlich parallel angeordnet. Bei der räumlich parallelen Anordnung erstreckt sich die Außenhaut des ersten Kühlkanals zumindest abschnittsweise parallel zur Außenhaut des zweiten Kühlkanals. Durch die räumlich parallele Anordnung können auch die Zwischenkreiskondensatoren und die Halbleiter parallel zueinander im Stromrichter angeordnet werden. Damit lässt sich auch im Hinblick auf das elektrische Verhalten ein besonders einfacher und niederinduktiver Geräteaufbau mit sehr einfachen Stromschienen zur Stromführung für die DC- und AC-Schienen erzielen. Aufgrund dieser Anordnung lässt sich das Bauvolumen des Stromrichters sehr kompakt und damit kostengünstig gestalten.

Im Folgenden wird die Erfindung anhand der in den Figuren dargestellten Ausführungsbeispiele näher beschrieben und erläutert. Es zeigen:
- FIG 1: zwei Kühlkanäle eines Stromrichters und
- FIG 2: einen Stromrichter.

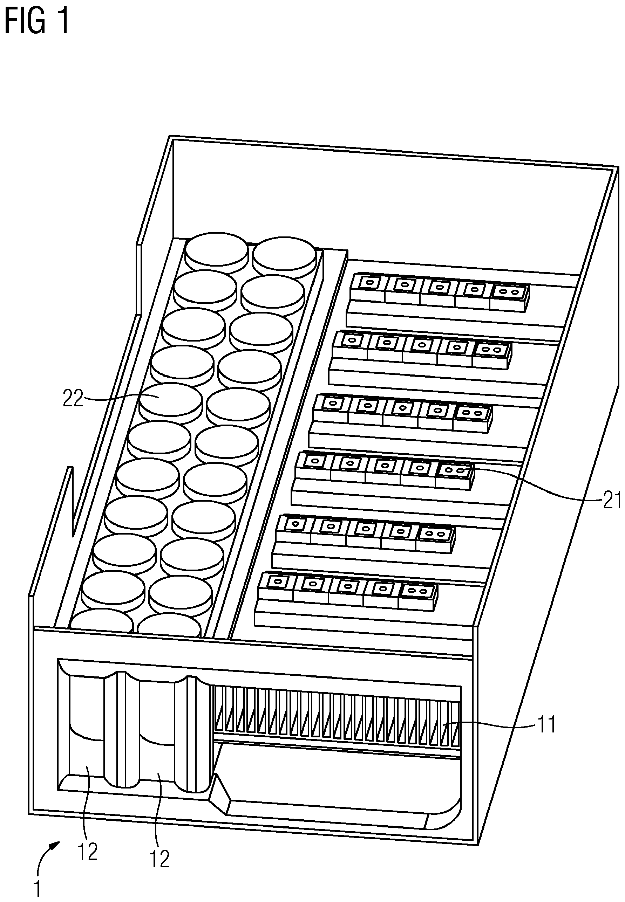

Die FIG 1 zeigt ein Kühlsystem 1 für die Verwendung des Kühlmediums Luft. Dieses Kühlsystem 1 weist einen ersten Kühlkanal 11 und einen zweiten Kühlkanal 12 auf. Diese erstrecken sich räumlich parallel durch den dargestellten Ausschnitt des Stromrichters 2. Deutlich zu erkennen sind die getrennten Kühlkanäle für die Kühlung der Halbleiter 21 und die Kühlung der Zwischenkreiskondensatoren 22. Dabei dient der erste Kühlkanal 11 zur Kühlung der Halbleiter 21, die auf einen Kühlkörper montiert sind. Die Kühlrippen des Kühlkörpers ragen in den ersten Kühlkanal 11. Damit geben die Halbleiter 21 die durch Verlustleistung erzeugte Wärme über den Kühlkörper an das Kühlmedium Luft ab. Eine Überhitzung der Halbleiter 21 kann somit zuverlässig verhindert werden.

Im zweiten Kühlkanal 12 sind die Zwischenkreiskondensatoren 22 angeordnet. Diese befinden sich im zweiten Kühlkanal 12 und werden von dem Kühlmedium Luft umspült. Dabei geben die Zwischenkreiskondensatoren 22 die Wärme ab, die aufgrund von Verlusten in den Kondensatoren entstehen. Da die Verlustleitung der Halbleiter 21 größer ist als die der Zwischenkreiskondensatoren 22 ist auch die wirksame Querschnittfläche des ersten Kühlkanals 11 größer als die wirksame Querschnittfläche des zweiten Kühlkanals 12. Die wirksame Querschnittsfläche ist die Querschnittsfläche des Kühlkanals 11, 12 abzüglich der darin hineinragenden Komponenten wie Zwischenkreiskondensatoren 22 oder Kühlrippen.

Zur Steuerung der Luftaufteilung zwischen den beiden Kühlkanälen 11, 12 dient ein hier nicht dargestellter Luftverteiler 4 am Eingang der beiden Kühlkanäle 11, 12. Mit diesem kann, beispielsweise abhängig vom Arbeitspunkt und/oder den an den Halbleitern 21 und/oder den Zwischenkreiskondensatoren 22 gemessenen Temperaturen, die Aufteilung der Kühlluft auf die beiden Kühlkanäle 11,12 gesteuert oder geregelt werden.

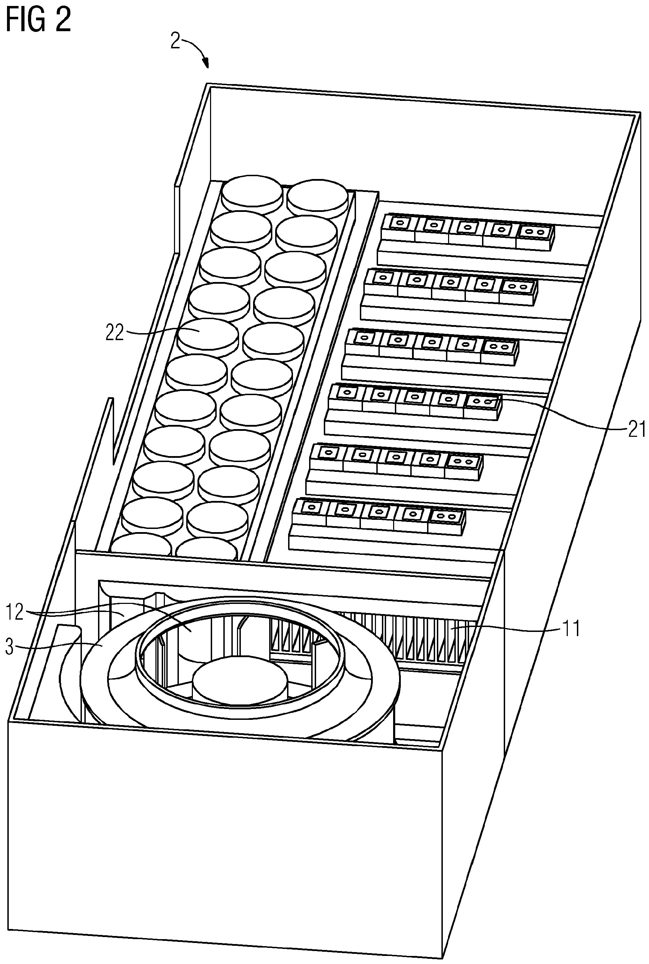

Die FIG 2 zeigt einen Stromrichter 2 mit einem Kühlsystem 1. Zur Vermeidung von Wiederholungen wird auf die Beschreibung zur FIG 1 sowie auf die dort eingeführten Bezugszeichen verwiesen. Zur Erzeugung eines Kühlluftstromes weist der Stromrichter 2 einen Lüfter 3 auf. Über den hier nicht dargestellten Luftverteiler 4 wird durch den Lüfter 3 ein Kühlluftstrom sowohl im ersten Kühlkanal 11 wie auch zweiten Kühlkanal 12 erzeugt.

Zusammenfassend betrifft die Erfindung ein Kühlsystem für einen Stromrichter. Zur Verbesserung des Kühlsystems wird vorgeschlagen, das Kühlsystem mit einem ersten Kühlkanal und einem zweiten Kühlkanal auszustatten, Wobei der erste und der zweite Kühlkanal zumindest abschnittsweise parallel angeordnet sind, wobei im Bereich der parallelen Anordnung der erste Kühlkanal zur Kühlung von Halbleitern des Stromrichters ausgebildet ist, wobei im Bereich der parallelen Anordnung der zweite Kühlkanal zur Kühlung von Zwischenkreiskondensatoren des Stromrichters ausgebildet ist. Ferner betrifft die Erfindung einen Stromrichter mit einem derartigen Kühlsystem.

## Patentansprüche

1. Kühlsystem (1) für einen Stromrichter (2), aufweisend
- einen ersten Kühlkanal (11)
- einen zweiten Kühlkanal (12)
wobei der erste und der zweite Kühlkanal (11,12) zumindest abschnittsweise parallel angeordnet sind, wobei im Bereich der parallelen Anordnung der erste Kühlkanal (11) zur Kühlung von Halbleitern (21) des Stromrichters (2) ausgebildet ist, wobei im Bereich der parallelen Anordnung der zweite Kühlkanal (12) zur Kühlung von Zwischenkreiskondensatoren (22) des Stromrichters (2) ausgebildet ist.

2. Kühlsystem (1) nach Anspruch 1, wobei die Kühlkanale (11,12) als Luftkanäle ausgebildet sind.

3. Kühlsystem (1) nach Anspruch 2, wobei das Kühlsystem (1) genau einen Lüfter (2) aufweist, der derart angeordnet ist, Kühlluftströme im ersten und im zweiten Kühlkanal (11,12) zu erzeugen.

4. Kühlsystem (1) nach einem der Ansprüche 2 oder 3, wobei das Kühlsystem (1) einen Luftverteiler aufweist, wobei der Luftverteiler derart ausgebildet ist, den Luftstrom zwischen dem ersten Kühlkanal (11) und dem zweiten Kühlkanal (12) im Verhältnis 90:10 aufzuteilen.

5. Kühlsystem (1) nach einem der Ansprüche 2 bis 4, wobei der erste und der zweite Kühlkanal (11,12) im Bereich der parallelen Anordnung räumlich parallel angeordnet sind.

6. Stromrichter (2) mit einem Kühlsystem (1) nach einem der Ansprüche 1 bis 5.
